Europäisches Patentamt

**European Patent Office**

Office européen des brevets

(19)

(11) Numéro de publication: **0 040 669**
**B1**

(12)

# FASCICULE DE BREVET EUROPEEN

(45) Date de publication du fascicule du brevet:
16.05.84

(51) Int. Cl.³: **H 01 L 21/60**

(21) Numéro de dépôt: 81101371.3

(22) Date de dépôt: 25.02.81

(54) Procédé d'élimination des plots de soudure demeurant sur un substrat céramique après retrait d'une microplaquette semi-conductrice, par absorption dans un bloc de cuivre poreux et application au retravaillage des modules.

(30) Priorité: 22.05.80 FR 8011755

(43) Date de publication de la demande:
02.12.81 Bulletin 81/48

(45) Mention de la délivrance du brevet:
16.05.84 Bulletin 84/20

(84) Etats contractants désignés:
DE FR GB

(56) Documents cités:
FR - A - 2 316 734

IBM TECHNICAL DISCLOSURE BULLETIN vol. 17, no. 1,
juin 1974 NEW YORK (US) P.A. TOTTA: "Integrated
circuit device recovery and restoration technique"
pages 113-114
IBM TECHNICAL DISCLOSURE BULLETIN, vol. 21, no. 5,
octobre 1978 NEW YORK (US) B.D. MARTIN:
"Individually flip-chip bonding semiconductor devices to
a substrate", pages 1854-1855

(73) Titulaire: **International Business Machines Corporation,
Old Orchard Road, Armonk, N.Y. 10504 (US)**
(84) Etats contractants désignés: **DE GB**

(73) Titulaire: **Compagnie IBM FRANCE, 5 Place Vendôme,
F-75000 Paris 1er (FR)**
(84) Etats contractants désignés: **FR**

(72) Inventeur: **Lecuyer, Alain Jean-Louis, 1, rue Verlaine,
F-91100 Corbeil-Essonnes (FR)**
Inventeur: **Lemoine, Jean-Marie, 16, rue Bizet,
F-91240 Saint Michel Sur Orge (FR)**
Inventeur: **Le Pape, Bernard Gabriel, 44, Allée Sisley,
F-77190 Dammarie Les Lys (FR)**
Inventeur: **Pottier, Bernard, Rue des Sables,
F-77210 Samoreau (FR)**

(74) Mandataire: **Klein, Daniel Jacques Henri, Compagnie
IBM France Département de Propriété Industrielle,
F-06610 La Gaude (FR)**

BUNDESDRUCKEREI BERLIN

**Procédé d'élimination des plots de soudure demeurant sur un substrat céramique après retrait d'une microplaquette semi-conductrice, par absorption dans un bloc de cuivre poreux et application au retravaillage des modules**

### Domaine Technique

La présente invention concerne le retravaillage des modules et plus particulièrement se rapporte à un procédé d'élimination des plots de soudure demeurant sur un substrat en céramique après le retrait d'une microplaquette semi-conductrice, fixée à des conducteurs formés sur le substrat par des colonnes de soudure, à un emplacement déterminé. Dans son essence la présente invention concerne un procédé d'élimination, dans lequel les plots de soudure sont absorbés par un bloc en cuivre micro poreux (pratiquement de la taille d'une microplaquette) qui est appliqué contre lesdits plots, pendant qu'un faisceau énergétique, assure la fusion de la soudure.

### Etat de la Technique

Les présents développements de la microélectronique vers une intégration à grande échelle imposent le recours à des modules comportant de nombreuses microplaquettes semiconductrices. Un tel module consiste par exemple en un substrat en céramique, du type multicouches. Les microplaquettes semi-conductrices sont soudées sur un réseau de conducteurs disposé sur une surface dite supérieure de ce module, à des emplacements déterminés.

Après avoir été protégé sur la surface supérieure, par des résines d'encapsulation spéciales, le substrat est enfermé dans un capot, généralement métallique tandis que la surface inférieure également protégée, est munie de broches d'entréesortie, pour assurer les liaisons électriques avec les circuits extérieurs.

La production de modules dont chaque substrat comporte 10 × 10 microplaquettes semiconductrices peut être dès maintenant envisagée. Ces microplaquettes sont elles-mêmes à forte densité d'intégration, et leur prix peut être fort élevé, ce qui rend finalement un tel module extrêmement coûteux.

Au cours de l'utilisation industrielle de ce type de modules à microplaquettes multiples, notamment dans des calculateurs à hautes performances, le besoin peut se faire sentir, d'avoir à changer une ou plusieurs microplaquettes, notamment parce qu'elle a été déterminée comme étant défectueuse. La probabilité de ce besoin est d'autant plus grande que le module comporte un plus grand nombre de microplaquettes. En d'autres termes ce que l'on recherche, c'est un procédé qui permet de retirer la microplaquette défectueuse, d'un emplacement déterminé, de remettre en état les colonnes de soudure qui se trouvent alors avec des hauteurs et des formes irrégulières, selon des standards déterminés, d'introduire le flux de soudure et enfin de disposer une nouvelle microplaquette munie de ses billes de soudure, à cet emplacement, selon une orientation désirée et de la fixer par la technique du reflux de soudure. Comme exemples de l'état de la technique, en ce qui concerne le retrait des microplaquettes par des procédés thermiques, on peut citer dans l'IBM Technical Disclosure Bulletin, les articles »Use of a Heated Gas Jet to Remove a Silicon Chip Soldered to a Substrate« Vol. 20, No. 9, février 1978, page 3725 et »Inverted hot Gas Selected Chip Removal« Vol. 21, No. 9, février 1979, page 3592. Cependant, l'opération la plus difficile est celle de la remise en état des colonnes de soudures, qui consiste pratiquement à éliminer la soudure, sans que cette élimination soit totale (pour faciliter la fixation de la nouvelle microplaquette). Il est donc souhaitable qu'un tel procédé soit rapide, simple et bon marché. Il ne doit, bien sûr, pas affecter les microplaquettes voisines, ni détériorer le réseau de conducteurs présents sur la surface du substrat, ni laisser des coulures de soudure susceptibles d'entraîner des courts-circuits non désirés entre conducteurs. Il ne doit pas être destructif, c'est-à-dire qu'il doit pouvoir être utilisé plusieurs fois pour un même emplacement.

Enfin il doit permettre le contrôle du volume et des dimensions des zones de soudure restantes, qui sont destinées, comme on l'a écrit ci-dessus à faciliter le placement et la fixation des microplaquettes nouvelles. Il y a dans l'état de la technique, de nombreux appareils et procédés pour l'étape de remise en état des colonnes de soudure. On pourra notamment se référer aux articles suivants de l'IBM Technical Disclosure Bulletin: »Centrifugal Solder Dress Process« Vol. 22, No. 9, février 1980, page 4044, »Cleaning of Solder Pads Prior to a Rework Operation« Vol. 18, No. 5, Octobre 1975, page 1384 et »LSI Chip Removal and Dressing Tool« Vol. 19, No. 5, octobre 1976, page 1641. Schématiquement on peut regrouper les procédés selon deux grandes techniques: les procédés thermiques et les procédés mécaniques.

Avec les procédés thermiques, la soudure est généralement fondue, puis retirée par soufflage, aspiration, ou encore en mouillant une microplaquette de simulation de façon que lorsque cette dernière est retirée, elle emporte avec elle, l'excès de soudure. Ces procédés thermiques ne sont pas totalement satisfaisants parce que soit complexes (utilisation d'une puce de simulation) ou longs (aspiration) ou cause de nombreux court-circuits et risque de fusion de colonnes voisines (soufflage). Dans la plus part des cas l'élimination est irrégulière et rarement suffisante. Avec ces procédés l'opération nécessite souvent une inspection visuelle et parfois des retouches, sinon il serait très difficile de placer correctement la nouvelle microplaquette et de la fixer en garantissant une bonne qualité de contact. Une technique d'élimination des plots de soudure disposées à la surface d'une microplaquette de silicium, selon la technique d'aspiration de la soudure fondue au travers d'une plaque perforée ou d'un matériau poreux du genre éponge, est décrite dans la publication de P. A. Totta: »Integrated circuit device recovery and restoration technique« parue dans l'IBM Technical Disclosure Bulletin Vol. 17, No. 1 juin 1974 pages 113 et 1.4.

Les procédés mécaniques comportent généralement l'utilisation d'une lame coupante qui sectionne à hauteur désirée les colonnes de soudure, ces procédés sont difficiles à mettre en oeuvre dès que la population de microplaquettes s'accroît et en outre ils conduisent aux mêmes défauts que ceux mentionnés ci-dessus en raison de la mauvaise planéïté des substrats en céramique.

Un procédé récent mettant en oeuvre une combinaison de ces deux techniques comporte l'application d'un masque muni d'ouvertures aux emplacements des colonnes de soudure. Les portions de colonnes qui dépassent du masque sont ramollies puis brossées. Ce dernier procédé présente les inconvénients suivants: il existe sur le marché de très nombreuses microplaquettes présentant des configurations de billes de soudure différentes, à chacune de ces microplaquettes devra correspondre un masque particulier. Si la microplaquette précédente a été mal retirée, les coulures de soudure peuvent empêcher l'application du masque. Enfin on comprend qu'avec cette technique et en raison de l'épaisseur du masque ( ≥ 20 microns), l'élimination de la soudure ne pourra être que partielle.

Exposé de l'Invention

Tel qu'il est exposé dans les revendications, le procédé d'élimination de plots de soudure portés par un substrat isolant, conforme aux enseignements de la présente invention comporte l'étape dé:

> application contre le substrat à l'emplacement choisi de la configuration de plots de soudure à éliminer d'un bloc solide microporeux ayant une grande capacité d'absorption et que l'on porte à la température de travail qui est celle de la soudure fondue de telle maniéré que les plots de sondure soient absorbés par la seule action des forces de capillarité.

Dans un mode de réalisation préféré, ce bloc sera constitué par du cuivre fritté et, éventuellement pré-étamé.

Le présent procédé s'est révélé simple, de mise en oeuvre facile, peu coûteux, présentant l'avantage de n'être tributaire ni de la configuration de billes de soudure, ni des défauts de planéïté du substrat. L'absorption est totale, sans risque de coulures. L'expérimentation a montré que la hauteur restante des plots était inférieure à 5 microns, elle était très régulière, ce qui présente un double avantage: présence (même si elle est minimum) d'une certaine quantité de soudure qui assure le pré-étamage des conducteurs et hauteur suffisamment faible et régulière pour que le placement et la fixation de la nouvelle microplaquette s'effectue dans les meilleures conditions.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève Description des Figures

La fig. 1 représente le principe du présent procédé d'élimination des plots de soudure demeurant sur la surface d'un substrat.

Les fig. 2, 3 et 4 montrent la mise en oeuvre de ce procédé dans le cadre plus général du retravaillage d'un module dont on veut retirer une microplaquette défectueuse pour la remplacer par une nouvelle.

Description de l'Invention

1. Principe

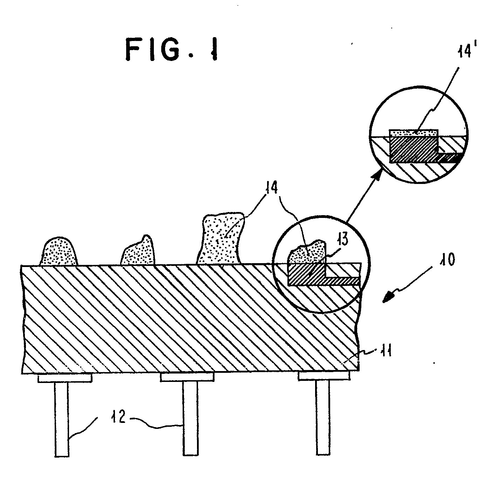

La fig. 1 représente schématiquement en coupe une portion d'un module électronique 10 dont le capot a été enlevé. Elle montre plus particulièrement un substrat 11, généralement du type multi-couches en céramique muni de ses broches de connexion 12, à l'emplacement d'une microplaquette reconnue défectueuse qui a été préalablement retirée. Cette microplaquette (non représentée) était reliée à des emplacements déterminés (par exemple 13) du réseau de conducteurs par des colonnes de soudure; lors du retrait de la microplaquette (étape qui sera décrite ci-après) ces colonnes de soudure sont restées avec des hauteurs et des formes irrégulières et constituent les plots 14. C'est le but du procédé d'élimination de soudure qui fait l'objet de la présente demande de ne laisser qu'une mince pellicule de soudure de hauteur contrôlée et très faible ( ≤ 5 microns telle que référencée en 14' dans l'encadré, parfaitement délimitée, au doigt du conducteur correspondant 13. Dans son principe, le nettoyage de ces plots de soudure 14 est obtenu en utilisant l'»effet d'éponge« particulièrement efficace d'un bloc de cuivre micro poreux, pré-étamé, combiné à l'application de chaleur pour fondre ces plots de soudure. L'action d'aspiration est assurée par les seules forces de capillarité, qui rendent donc inutile l'utilisation du vide, contrairement aux techniques de l'art antérieur. Ce bloc est obtenu par un frittage limité en atmosphère d'hydrogène de billes de cuivre de diamètre contrôlé.

## 2. Mode de réalisation préfère du procédé de retravaillage

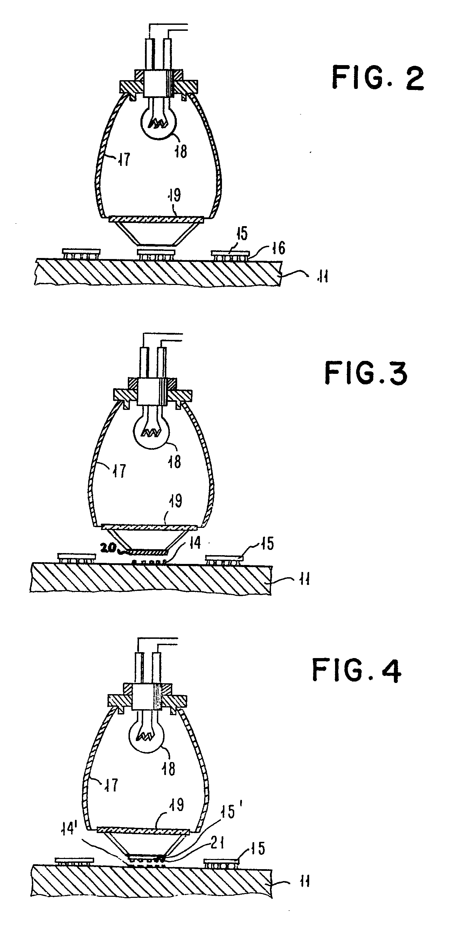

Le Procédé de retravaillage d'un module va être décrit à l'aide des fig. 2 à 4.

Sur la fig. 2 on a représenté schématiquement l'étape de retrait d'une microplaquette jugée défectueuse. Un fragment d'un substrat en céramique 11 supportant trois microplaquettes semi-conductrices 15, grâce à des colonnes de soudure 16. Ce fragment peut avoir été préalablement réchauffé. L'appareil de retrait des microplaquettes est représentée de façon très simplifiée, il comporte un bulbe réfléchissant 17 d'une forme appropriée pour limiter l'action de retrait à une seule microplaquette et d'une source de chaleur 18 destinée à chauffer localement l'emplacement choisi, par exemple une lampe infrarouge disposée au-dessus d'une fenêtre en quartz 19. D'autres moyens équivalents, tels qu'un faisceau laser ou une microflamme peuvent être également utlisés. En outre la forme du bulbe permet en combinaison avec des moyens à vide (non représentés), d'assurer un effet de préhension utile pour la manipulation des microplaquettes. Le bulbe est positionné au-dessus de la microplaquette à retirer, par exemple à l'aide d'un système optique (non représenté), la source de chaleur est activée et on fait circuler un courant d'azote dans le bulbe. Quand la soudure est suffisamment ramollie, le bulbe est alors mis en contact avec le vide et la microplaquette est aspirée, laissant des plots de soudure 14 tels que ceux représentés sur les fig. 1 et 3. On libère alors la microplaquette défectueuse qui peut être récupérée et analysée le cas échéant. Un équipement approprié est décrit dans la demande de brevet européen déposée par la demanderesse le 13 novembre 1978 sous le numéro 78 300 619.0 et publiée sous le numéro 2 884. A l'étape soivante montrée sur la fig. 3 on vient placer au-dessus de l'emplacement des plots 14, un bloc de cuivre micro-poreux pré-étamé et préfluxé 20 maintenu par le bulbe faisant office de pipette. Ce bloc est pratiquement aux dimensions des microplaquettes 15. Ensuite, le bulbe vient l'appliquer fermement contre les plots de soudure pendant que la source de chaleur est mise de nouveau en action, sous un jet d'azote, quand les plots de soudure et le bloc de cuivre ont atteint la température désirée de fusion de la soudure, celle-ci est instantanément absorbée par le bloc; ce dernier est alors retiré à chaud puis placé en attente d'une opération ultérieure.

Divers essais ont été réalisés avec un bloc de cuivre massif (principe de la panne à souder) mais il n'y avait pas élimination satisfaisante des plots de soudure et en plus l'opération dure longtemps; des résultats meilleurs ont été obtenus avec un bloc de cuivre doré mais il y avait alors un risque de contamination de la soudure par de l'or, et donc un risque au niveau de la fiabilité.

D'autres essais ont porté sur une tresse de cuivre, mais dans ce cas la surface n'était pas suffisamment plane pour assurer une élimination régulière de la soudure.

Sur la fig. 4 on a représenté le bulbe 17 maintenant une nouvelle microplaquette 15' au-dessus de l'emplacement choisi. Après élimination de la soudure en excès, les plots de soudure restants sont montrés sur la figure par la référence 14'.

On procédé alors aux opérations suivantes: le bulbe agissant comme dispositif de manipulation vient placer la nouvelle microplaquette 15' (avec une pression de pose inférieure à 600 g), préalablement préfluxée, munie de ses billes de soudure 21 contre les plots de soudure 14'. On souffle de l'azote dans le bulbe pour décoller la microplaquette de l'extrémité du bulbe. On relève alors légèrement le bulbe puis on chauffe à la température désirée pour que se forment les nouvelles colonnes de soudure. Le courant d'azote est alors arrêté et on fait remonter le bulbe en position de repos.

On peut noter que, grâce à la nouvelle étape d'élimination de soudure qui laisse des plots très minces ($\leq$ 5 microns) et uniformes, qui ne nécessite donc pas une étape supplémentaire d'inspection visuelle et de retouche manuelle, toutes les opérations ci-dessus peuvent être entièrement automatisées et réalisées en une seule passe, si plusieurs microplaquettes doivent être remplacées. En outre on notera que le procédé et l'appareil mise en oeuvre n'ont d'effet que sur un emplacement (une microplaquette) bien déterminée sans action sur les autres.

## 3. Mode de fabrication prefere des blocs de cuivre

Des matériaux autres que le cuivre, par exemple le nickel, sont susceptibles d'être utilisés, cependant l'expérimentation a montré que le cuivre assurait les meilleurs résultats.

La préparation de la pâte consiste à mélanger dans un becher, 10 g de poudre de cuivre (référence 21 GS 300 TV fabriquée par la Société Baudier) avec 0,8 g de camphre et 0,7 cc d'alcool isopropylique, puis à laisser reposer deux heures. La pâte est retournée toutes les 30 minutes. La pâte est alors tamisée (écran de 165 mesh 4) pour être bien homogène. On pèse environ 0,15 g de cette poudre, que l'on verse dans une matrice comportant un poinçon et un contre poinçon, on applique alors sur ces poinçons une pression d'environ 1000 bars pendant environ 10 secondes pour assurer le pressage et la formation d'un bloc d'environ 5 × 5 × 1,5 mm. Les blocs obtenus sont disposés sur des plaques d'alumine et introduits dans un four. La température d'introduction du chargement est de l'ordre de 60°C. Puis sous atmosphère d'hydrogène, la température est portée à 800°C environ ce qui assure l'élimination du camphre et de l'alcool et donc l'agglomération des billes de cuivre. On obtient des blocs de cuivre poreux. Il est recommandé que ces blocs soient étamés, le procédé suivant peut être utilisé. On verse du flux sur une plaque de verre et on l'étend avec une lame à sérigraphier, parallèlement on étale à épaisseur constante, avec une lame à sérigraphier, de la poudre de soudure (Pb-Sn 63/37) ¬près tamisage sur une deuxième plaque de verre. On prend les blocs de cuivre un à un, on les pose sur la première plaque de verre pour qu'ils s'imprègnent de flux, puis sur la deuxième plaque de verre qui comporte le lit de soudure. Ainsi revêtus les blocs de cuivre sont introduits dans un four (330° pendant environ 2 mn pour faire l'étamage des blocs. Enfin les blocs sont rincés dans un bain à agitation ultrasonique contenant du xylène.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

## Revendications

1. Procédé d'élimination des plots de soudure (14) demeurant sur un substrat isolant (11) après le retrait d'une microplaquette semi-conductrice, caractérisé en ce qu'on vient appliquer un bloc (20) de matériau micro-poreux ayant une grand capacité d'absorption contre lesdits plots et en ce que l'on chauffe le bloc, afin de faire fondue les plots de soudure, lesdits plots étant alors absorbés par la seule action des forces de capillarité.

2. Procédé selon la revendication 1, caractérisé en ce que ledit bloc est un bloc de cuivre fritté pré-étamé.

3. Procédé selon la des revendication 2, caractérisé en ce que ledit bloc de cuivre est obtenu par frittage à chaud de billes de cuivre dans un liant sous atmosphère contrôlée d'hydrogène.

4. Procédé selon la revendication 3, caractérisé en ce que le chauffage est effectué par un rayonnement infra-rouge, par un laser ou par microflamme.

## Patentansprüche

1. Verfahren zum Eliminieren von Lothöckern (14), die auf einem isolierenden Substrat (11) nach der Entfernung eines Halbleiterchips zurückblieben, dadurch gekennzeichnet, daß ein aus einem porösen Stoff bestehender Block (20) mit einer großen Absorptionsfähigkeit an den Lothöckern gedrängt ist, und dieser Block so erhitzt wird, daß die Lothöcker zum Schmelzen gebracht sind, wobei die Lothöcker mit der alleinigen Wirkung der Kapillaritätskräfte absorbiert sind.

2. Verfahren nach Anspruch 1, dadurch gekennzeichnet, daß der Block ein gesinterter vorverzinnter Kupferblock ist.

3. Verfahren nach Anspruch 2, dadurch gekennzeichnet, daß der Block unter Anwendung der warmen Sinterung von Kupferballen in einem Bindemittel in einer gesteuerten Wasserstoffatmosphäre hergestellt ist.

4. Verfahren nach Anspruch 3, dadurch gekennzeichnet, daß das Erhitzen mit einer Infrarotstrahlung, mit einer Laserstrahlung oder mit einer Mikroflamme durchgeführt ist.

## Claims

1. A method for eliminating the solder pads (14) remaining on an insulating substrate (11) after removing a semiconductor chip, characterized in that a block (20) consisting of a porous matter having a high absorption capacity, is pressed against said pads, and in that the block is heated in order to cause the solder pads to melt, said pads, then, being absorbed upon mere action of capillarity forces.

2. A method according to claim 1, characterized in that said block is a pre-tinned sintered copper block.

3. A method according to claim 2, characterized in that said copper block is obtained by hot sintering of copper balls in a binding substance in a controlled hydrogen atmosphere.

4. A method according to claim 3, characterized in that heating is performed by infrared radiation, by means of a laser or by means of a microflame.

# FIG. 1

FIG. 2

FIG.3

FIG. 4